**Europäisches Patentamt**

**European Patent Office**

**Office européen des brevets**

(19)

(11) Veröffentlichungsnummer : **0 067 338 B2**

# (12) NEUE EUROPÄISCHE PATENTSCHRIFT

(45) Veröffentlichungstag der neuen Patentschrift :
**27.12.91 Patentblatt 91/52**

(51) Int. Cl.⁵ : **G01C 17/38, G01R 33/02**

(21) Anmeldenummer : **82104676.0**

(22) Anmeldetag : **27.05.82**

(54) **Korrekturverfahren für eine Magnetfeldsonde.**

(30) Priorität : **11.06.81 DE 3123180**

(43) Veröffentlichungstag der Anmeldung :
**22.12.82 Patentblatt 82/51**

(45) Bekanntmachung des Hinweises auf die
Patenterteilung :
**20.11.86 Patentblatt 86/47**

(45) Bekanntmachung des Hinweises auf die
Entscheidung über den Einspruch :
**27.12.91 Patentblatt 91/52**

(84) Benannte Vertragsstaaten :
**AT BE CH DE FR GB IT LI NL**

(56) Entgegenhaltungen :
**DE-A- 1 540 069
DE-A- 2 727 132**

(56) Entgegenhaltungen :
**DE-C- 2 358 197
GB-A- 1 371 395
GB-A- 1 540 069
US-A- 3 991 361
US-A- 4 143 467
US-A- 4 192 074
VDO Marine,Koppelnavigator mit Sollkurseinsteller,2.Ausgabe Juni 1979,S.12-13.**

(73) Patentinhaber : **SIEMENS
AKTIENGESELLSCHAFT
Wittelsbacherplatz 2
W-8000 München 2 (DE)**

(72) Erfinder : **Scherer, Hartmut, Dipl.-Ing.
Tölzer Strasse 37
W-8000 München 70 (DE)**
Erfinder : **Thilo, Peer, Dr.
Buchhierlstrasse 19
W-8000 München 71 (DE)**

EP 0 067 338 B2

EP 0 067 338 B2

## Beschreibung

Die Erfindung bezieht sich auf ein Korrekturverfahren zur Kompensation eines Störmagnetfeldes.

Magnetfeldsonden als elektronische Kompasse sind bereits in verschiedenen Formen bekannt. Beispielsweise sind solche Sonden mit zwei aufeinander senkrecht stehenden Spulen aufgebaut, deren Induktion durch das Erdmagnetfeld oder ein sonstiges äusseres Magnetfeld beeinflusst wird. Messverfahren, die diesen Effekt ausnutzen, sind beispielsweise in den älteren deutschen Patentanmeldungen DE-A-2 949 815, DE-A-3 029 532 und DE-A-3 121 234 beschrieben.

Bei der Verwendung von Kompassen, insbesondere in Fahrzeugen, etwa in Schiffen, Flugzeugen oder auch in Landfahrzeugen, treten verschiedene Fehler auf, die sich durch eine Missweisung bemerkbar machen. Diese Missweisung entsteht einerseits durch unerwünschte Magnetfelder im Fahrzeug oder in der Sonde selbst, andererseits durch einen nicht genau horizontalen Einbau der Sonde. Ein weiterer Fehler kann sich durch die Art der Sonde ergeben. Misst man beispielsweise in der Sonde mit zwei verschiedenen Spulen die zwei Komponenten des Magnetfeldes, so können sich Fehler durch Ungleichheiten der beiden Spulen oder in der Auswerteelektronik ergeben.

Um Missweisungen bei Kompassen zu vermeiden, ist es bereits bekannt, das Fahrzeug mit dem eingebauten Kompass auf einer Kompensationsplattform langsam um 360° zu drehen. Dabei wird Punkt für Punkt eine Tabelle erstellt, aus der die Zuordnung zwischen angezeigtem und wirklichem Winkel gegenüber der Nordrichtung hervorgeht. Eine andere Möglichkeit der Korrektur besteht darin, mit Hilfe von einzeln angebrachten Kompensationsmagneten die Missweisung zu verringern. Beide Massnahmen sind in ihrer Durchführung aufwendig. Insbesondere sind sie schwer zu automatisieren bzw. führen sie zu einem hohen apparativen Aufwand.

Ein Korrekturverfahren zur Kompensation eines Störmagnetfeldes ist in der US-A-3 991 361 beschrieben. Dort ist vorgesehen, bei einer Kreisbewegung des Fahrzeuges mit der Sonde um 360° bestimmte Messwerte festzustellen, aus denen die Grösse des Störmagnetfeldes abgeleitet und zur Korrektur ausgewertet werden kann. Diese Korrektur erfolgt dort in der Weise, dass entsprechend dem Messergebnis eine Rückkopplung zu den Wicklungen der Sonde erfolgt und eine dem Störfeld entsprechende Kompensationserregung vorgenommen wird. Die Ermittlung des Störmagnetfeldes bei dem bekannten Verfahren erfolgt dadurch, dass jeweils beim Nulldurchgang der einen Feldkomponente die andere Feldkomponente gemessen wird. Durch Addition und Mittelwertbildung dieser Messwerte können dann die Störfeldkomponenten errechnet werden. Die Feststellung des Nulldurchgangs erfordert jedoch verhältnismässig komplizierte und empfindliche Messgeräte. Ausserdem ist bei dem bekannten System die Berechnung des Störmagnetfeldes nur dann möglich, wenn dieses nicht grösser ist als das Nutzsignal. Das bedeutet, dass die Sonde nicht im Fahrzeug oder nahe am Fahrzeug angebracht werden kann, sondern unter Umständen mit einem gewissen Aufwand in einem möglichst grossen Abstand vom Fahrzeug angebracht werden muss.

Aufgabe der Erfindung ist es demgegenüber, eine Messwertkorrektur für die Magnetfeldsonde mit möglichst einfachen Mitteln und verhältnismässig einfachen Geräten zu ermöglichen. Dabei soll diese Korrektur sehr genau sein und unmittelbar zur Ausgabe des richtigen Messergebnisses führen.

Erfindungsgemäss wird diese Aufgabe mit den Merkmalen des Patentanspruchs 1 gelöst.

Die Erfindung beruht auf der Erkenntnis, dass sich alle Störeinflüsse durch unerwünschte Fremdmagnetfelder zu einem Störvektor addieren lassen und dass dieser Störvektor durch Addition eines entgegengesetzt gerichteten Vektors mit dem gleichen Betrag kompensiert werden kann. Da es eine ganz bestimmte Richtung gibt, bei der der Feldvektor des zu messenden Magnetfeldes mit dem Störvektor in der Richtung übereinstimmt, wird in dieser Richtung ein maximaler Wert gemessen, während sich bei einer Drehung von 180° gegenüber diesem Maximalwert der Störvektor vom Feldvektor subtrahiert und dadurch einen minimalen Messwert hervorruft. Durch die erfindungsgemässe Messung von Maximal- und Minimalwert und durch Halbierung der Vektorsumme läss sich also der Störvektor ermitteln und ein entsprechend entgegengesetzter Korrekturvektor einspeichern, welcher dann bei der Magnetfeldmessung automatisch zu jedem Messergebnis addiert wird.

Die Durchführung des Korrekturverfahrens hängt von der Art des verwendeten Messverfahrens bzw. von der Art der Sonde ab. Wird die Messung im Polarkoordinatensystem durchgeführt, so kann der Korrekturvektor durch vektorielle Addition der betragsmässigen Maximal- und Minimalwerte des Mägnetfeldvektors sowie durch betragsmässige Halbierung und Invertierung der Vektorsumme gewonnen werden. Der Winkel des Korrekturvektors ist also in diesem Fall um 180° gegenüber dem bei der Eichung ermittelten Maximalwert des Feldvektors verschoben.

Die Erfindung wird nachfolgend an einem Ausführungsbeispiel anhand einer Zeichnung näher erläutert. Es zeigt

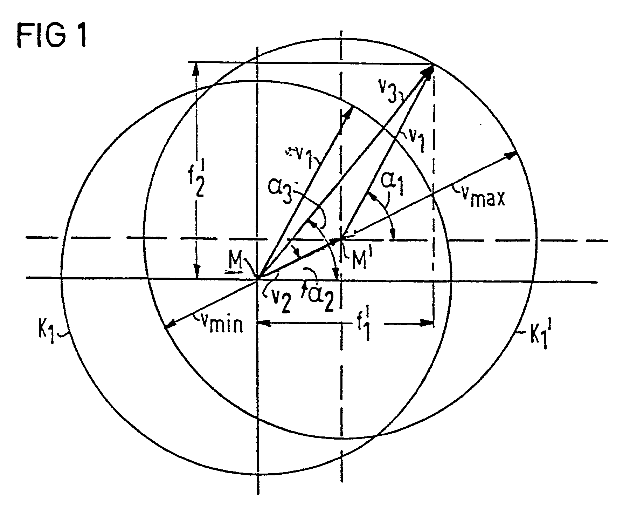

Figur 1 eine Prinzipdarstellung eines zu messenden Magnetfeldvektors mit Störvektor in einem Polarkoordinatensystem.

Figur 1 zeigt in einem Polarkoordinatensystem schematisch die Magnetfeldmessung mit und ohne Störein-

2

fluss. Im Mittelpunkt M befindet sich die Magnetsonde bzw. das die Sonde tragende Fahrzeug. Mit der Sonde wird ein das äussere Magnetfeld beschreibender Vektor gemessen, der jeweils Betrag und Richtung der äusseren Feldlinien gegenüber einer festgelegten Mittelachse der Sonde bzw. des Fahrzeugs angibt. Dabei beschreibt der Vektor $v_1$ das äussere Magnetfeld (Erdmagnetfeld). Wären keine Störeinflüsse vorhanden, so wäre der Betrag diese Vektor bei einer Kreisfahrt immer gleich. Die Spitze des Vektors würde sich auf dem Kreis K1 um den Mittelpunkt M bewegen.

Ist jedoch ein zusätzlicher Störvektor $v_2$ vorhanden, so addiert sich dieser Störvektor zum Magnetfeldvektor $v_1$, so dass sich der Magnetfeldvektor $v_1$ scheinbar um einen Mittelpunkt M' dreht. Gemessen bzw. errechnet wird deshalb bei der Kreisfahrt des Fahrzeugs ein Vektor $v_3$, der sich aus der vektoriellen Addition des festen Störvektors $v_2$ und des entsprechend der Fahrzeugbewegung veränderlichen Magnetfeldvektors $v_1$ ergibt. Dieser errechnete Vektor $v_3$ unterscheidet sich vom wirklichen Feldvektor $v_1$ nicht nur im Betrag, sondern auch im Winkel $\alpha_3$ gegenüber dem tatsächlichen Winkel $\alpha_1$.

Der gemessene Vektor $v_3$ erreicht dann seinen Maximalwert $v_{max}$, wenn der Winkel des Erdmagnetfeldes $\alpha_1$ mit dem Winkel des Störvektors $\alpha_2$ übereinstimmt, und er erreicht demgegenüber bei einer Drehung um 180° das Minimum, wenn der Magnetfeldvektor $v_1$ und der Störvektor $v_2$ sich genau entgegengesetzt überlagern. Durch Messung dieser Extremwerte $v_{max}$ und $v_{min}$ lässt sich der Störvektor ermitteln, und zwar dem Betrag nach:

$$|v_2| = \left| \frac{v_{max} + v_{min}}{2} \right|$$

Der Winkel des Störvektors entspricht dem Winkel von $v_{max}$, da in diesem Moment

$$\alpha_1 = \alpha_2 = \alpha_3$$

Ein Korrekturvektor muss also dem Störvektor $v_2$ genau entgegengerichtet sein und diesem betragsmässig entsprechen.

## Patentansprüche

1. Korrekturverfahren bei der Messung des Erdmagnetfeldes mittels einer an einem Fahrzeug angeordneten Magnetfeldsonde, zur Kompensation eines in dem Farhzeug oder in der Magnetfeldsonde auftretenden Störmagnetfeldes, wobei in einer Eichfahrt vor Beginn der Messfahrt das Fahrzeug mit der Sonde in einem Kreis bewegt wird, während laufend durch die Sonde Messwerte für die Magnetfeldstärke nach Betrag und Richtung gegenüber dem Fahrzeug ermittelt und zur Richtungsbestimmung für das Fahrzeug ausgewertet werden, wobei bei der Kreisbewegung des Fahrzeuges durch automatischen Vergleich aller Magnetfeld-Messwerte der Maximalwert und der Minimalwert der Magnetfeldstärke ermittelt werden, und dabei über eine Rechenvorrichtung aus der halbierten Vektorsumme dieser beiden Werte ein Störfeldvektor ermittelt und gespeichert wird, und wobei bei der nachfolgenden Messfahrt der invertierte Störfeldvektor als Korrekturvektor zu den einzelnen Messwerten automatisch vektoriell addiert wird.

## Claims

1. Correction process in the measurement of the earth's magnetic field by means of a magnetic field probe arranged at a vehicle, for compensating for an interfering magnetic field occurring in the vehicle or in the magnetic field probe, the vehicle with the probe being moved in a circle in a calibration run before beginning the measuring run whilst the probe continuously determines amount and direction measurement values for the magnetic field strength with respect to the vehicle and these values are evaluated for determining the direction of the vehicle, the maximum and the minimum value of the magnetic field strength being determined by automatic comparison of all magnetic field measurement values during the circular movement of the vehicle and an interfering-field vector being determined from the halved vector sum of these two values and being stored via a computing device, and the inverted interfering-field vector being automatically vectorially added to the individual measurement values as correction vector during the subsequent measuring run.

3

**Revendications**

1. Procédé de correction lors de la mesure du champ magnétique terrestre, au moyen d'une sonde de champ magnétique montée sur un véhicule et destinée à la compensation d'un champ magnétique parasite se produisant dans le véhicule ou dans la sonde de champ magnétique, qui consiste à déplacer, lors d'un déplacement d'étalonnage exécuté avant le début du déplacement de mesure, le véhicule muni de la sonde sur un cercle, tout en déterminant en permanence par la sonde des valeurs de mesure des intensités du champ magnétique en valeur et en direction par rapport au véhicule et en les exploitant, pour déterminer la direction du véhicule, à déterminer lors du déplacement circulaire du véhicule, la valeur maximale et la valeur minimale de l'intensité du champ magnétique au moyen d'une comparaison automatique de toutes les valeurs de mesure du champ magnétique, à déterminer un vecteur du champ parasite par l'intermédiaire d'un dispositif de calcul à partir du vecteur somme, divisé par deux, de ces deux valeurs et à le mémoriser et à additionner automatiquement de façon vectorielle, lors du déplacement ultérieur de mesure, l'inverse du vecteur du champ parasite, en tant que vecteur de correction, aux différentes valeurs de mesure.

# FIG 1